# EUROPEAN PATENT APPLICATION

(11) **EP 4 676 170 A1**
(43) Date of publication of application: **07.01.2026**
(21) Application number: 24832208.3
(22) Date of filing: 24.04.2024
(51) Int. Cl.: H05K 1/02, H05K 1/11, C09K 5/10

(54) **PRINTED CIRCUIT BOARD STRUCTURE ACCOMMODATING THERMAL INTERFACE MATERIAL, AND ELECTRONIC DEVICE COMPRISING SAME**

(30) Priority: 26.06.2023 KR 20230081724; 14.08.2023 KR 20230106374
(71) Applicant: Samsung Electronics Co., Ltd, Suwon-si, Gyeonggi-do 16677 (KR)
(72) Inventor: KIM, Joohan, Suwon-si, Gyeonggi-do 16677 (KR); CHO, Yonglak, Suwon-si, Gyeonggi-do 16677 (KR); PARK, Min, Suwon-si, Gyeonggi-do 16677 (KR)
(74) Representative: HGF
(86) International application number: PCT/KR2024/005494
(87) International publication number: WO 2025/005423

(57) **Abstract**

According to an embodiment, a printed circuit board (PCB) structure may include: a first PCB; an interposer; a second PCB; and a cover structure including a mounting layer which is connected to the second PCB and includes a base hole, a support layer which is on a surface of the mounting layer that faces away from the second PCB, and a visible layer which is connected to the support layer and includes a material having transparency.

## Description

### BACKGROUND

### 1. Field

Various embodiments of the present disclosure relate to a printed circuit board (PCB) structure and an electronic device, for example, a PCB structure for accommodating a thermal interface material and an electronic device including the same.

### 2. Description of Related Art

An electronic device may generate a large amount of heat due to its high performance and implementation of various functions. The heat dissipation performance of the electronic device is essential to secure product stability and reliability. Accordingly, technology for heat dissipation inside an electronic device in a limited space is being actively studied.

A technique for heat dissipation by injecting a liquid thermal interface material (TIM) into the inner space of an electronic device and hardening the TIM injected therein has been known.

### SUMMARY

According to embodiments of the present disclosure, an electronic device is provided and includes a printed circuit board (PCB) structure containing a thermal interface material (TIM). The PCB structure includes: a first PCB; an interposer connected to the first PCB; a second PCB connected to the interposer, wherein a nozzle hole and a monitoring hole are formed through the second PCB; and a cover structure. The cover structure includes: a support layer on the second PCB; and a visible layer that is connected to the support layer, covers the monitoring hole, and includes a material having transparency, wherein a hole overlapping the monitoring hole is formed through the support layer.

According to embodiments of the present disclosure, a PCB structure is provided and includes: a first PCB; an interposer connected to the first PCB; a second PCB including a cover body connected to the interposer, a nozzle hole formed through the cover body, and a monitoring hole formed through the cover body; and a cover structure including: a mounting layer connected to the second PCB, the mounting layer including a base hole communicating with the monitoring hole, a support layer on a surface of the mounting layer that faces away from the second PCB, the support layer including a body hole communicating with the base hole, and a visible layer that is connected to the support layer, covers the monitoring hole, and includes a material having transparency, wherein the PCB structure contains a thermal interface material (TIM).

According to embodiments of the present disclosure, an electronic device is provided and includes a printed circuit board (PCB) structure containing a thermal interface material (TIM). The PCB structure includes: a first PCB; an interposer connected to the first PCB; a second PCB including a cover body connected to the interposer, a nozzle hole formed through the cover body, and a monitoring hole formed through the cover body; and a cover structure including a mounting layer connected to the second PCB, the mounting layer including a base hole communicating with the monitoring hole, a support layer on a surface of the mounting layer that faces away from the second PCB, the support layer including a body hole communicating with the base hole, and a visible layer that is connected to the support layer, covers the monitoring hole, and includes a material having transparency, wherein the visible layer blocks the TIM from being discharged to an outside of the PCB structure through the monitoring hole, includes a non-conductive material, and has a thickness greater than a thickness of the mounting layer.

### BRIEF DESCRIPTION OF THE DRAWINGS

The foregoing and other aspects, features, and advantages of embodiments of the present disclosure will become apparent from the following detailed description with reference to the accompanying drawings.
FIG. 1 is a block diagram illustrating an electronic device in a network environment according to an embodiment.
FIG. 2 is a plan view of a printed circuit board (PCB) structure containing a thermal interface material (TIM) according to an embodiment.
FIG. 3 is a cross-sectional view taken along a line III-III of FIG. 2.
FIG. 4 is a cross-sectional view taken along a line IV-IV of FIG. 2.
FIG. 5 is a cross-sectional view of a PCB structure illustrating a state in which the inside of the PCB structure is filled with a TIM according to an embodiment.
FIG. 6 is a cross-sectional perspective view of a cover structure according to an embodiment.
FIG. 7 is an exploded perspective view of a cover structure according to an embodiment.
FIG. 8A is a plan view of a cover structure according to an embodiment.
FIG. 8B is a plan view of a cover structure in a state in which the inside of a PCB structure is filled with a TIM according to an embodiment.
FIG. 9 is a cross-sectional view of a PCB structure according to an embodiment.
FIG. 10 is a cross-sectional view of a PCB structure illustrating a state in which the inside of the PCB structure is filled with a TIM according to an embodiment.
FIG. 11 is an exploded perspective view of a cover structure according to an embodiment.
FIG. 12A is a plan view of a cover structure according to an embodiment.
FIG. 12B is a plan view of a cover structure in a state in which the inside of a PCB structure is filled with a TIM according to an embodiment.
FIG. 13 is an exploded perspective view of a cover structure according to an embodiment.
FIG. 14 is a plan view of a cover structure according to an embodiment.
FIG. 15 is a plan view of a cover structure according to an embodiment.
FIG. 16 is a plan view of a cover structure according to an embodiment.
FIG. 17 is an exploded perspective view of a cover structure according to an embodiment.
FIG. 18 is a cross-sectional view of a PCB structure according to an embodiment.

### DETAILED DESCRIPTION

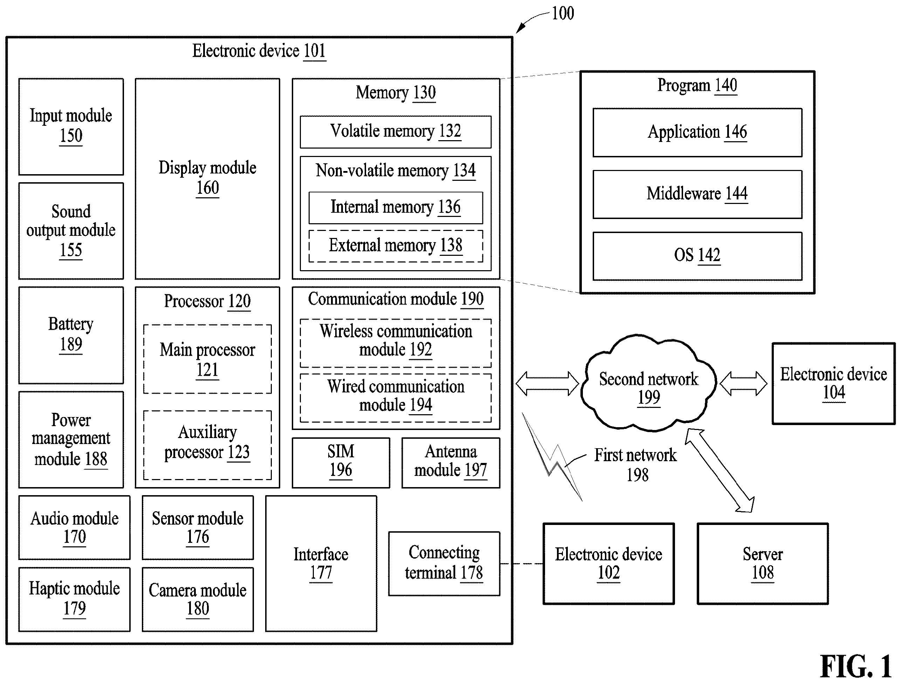

FIG. 1 is a block diagram illustrating an electronic device in a network environment according to an embodiment.

Referring to FIG. 1, an electronic device 101 in a network environment 100 may communicate with an electronic device 102 via a first network 198 (e.g., a short-range wireless communication network), or at least one from among an electronic device 104 and a server 108 via a second network 199 (e.g., a long-range wireless communication network). According to an embodiment, the electronic device 101 may communicate with the electronic device 104 via the server 108. According to an embodiment, the electronic device 101 may include a processor 120, a memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, and/or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)) and/or an auxiliary processor 123 (e.g., a graphics processing unit (GPU), a neural processing unit (NPU), an image signal processor (ISP), a sensor hub processor, and/or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed by, for example, the electronic device 101 where the artificial intelligence is performed, or via a separate server (e.g., the server 108). Learning algorithms may include, but are not limited to, e.g., supervised learning, unsupervised learning, semi-supervised learning, and/or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network, or a combination of two or more thereof, but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, and/or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker and/or a receiver. The speaker may be used for general purposes, such as playing multimedia or playing a record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, and/or a projector and control circuitry to control a corresponding one of the display, hologram device, and projector. According to an embodiment, the display module 160 may include a touch sensor adapted to detect a touch, and/or a pressure sensor adapted to measure the intensity of force incurred by the touch.

The audio module 170 may convert a sound into an electrical signal and vice versa. According to an embodiment, the audio module 170 may obtain the sound via the input module 150 and/or output the sound via the sound output module 155 or an external electronic device (e.g., an electronic device 102 such as a speaker or a headphone) directly or wirelessly coupled with the electronic device 101.

The sensor module 176 may detect an operational state (e.g., power or temperature) of the electronic device 101 and/or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, and/or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high-definition multimedia interface (HDMI), a universal serial bus (USB) interface, a secure digital (SD) card interface, and/or an audio interface.

The connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, and/or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, and/or an electric stimulator.

The camera module 180 may capture a still image and moving images. According to an embodiment, the camera module 180 may include one or more lenses, image sensors, image signal processors, and/or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, and/or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor) and support direct (e.g., wired) communication or wireless communication. According to an embodiment, the communication module 190 may include a wireless communication module 192 (e.g., a cellular communication module, a short-range wireless communication module, and/or a global navigation satellite system (GNSS) communication module) and/or a wired communication module 194 (e.g., a local area network (LAN) communication module, and/or a power line communication (PLC) module). A corresponding one of these communication modules may communicate with the external electronic device (e.g., the electronic device 104) via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multiple components (e.g., multiple chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network, and next-generation communication technology, e.g., new radio (NR) access technology. The NR access technology may support enhanced mobile broadband (eMBB), massive machine type communications (mMTC), and/or ultra-reliable and low-latency communications (URLLC). The wireless communication module 192 may support a high-frequency band (e.g., a mmWave band) to achieve, e.g., a high data transmission rate. The wireless communication module 192 may support various technologies for securing performance on a high-frequency band, such as, for example, beamforming, massive multiple-input and multiple-output (massive MIMO), full dimensional MIMO (FD-MIMO), array antenna, analog beam-forming, and/or large scale antenna. The wireless communication module 192 may support various requirements specified in the electronic device 101, an external electronic device (e.g., the electronic device 104), and/or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 from the plurality of antennas. The signal or the power may be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to an embodiment, the antenna module 197 may form a mmWave antenna module. According to an embodiment, the mmWave antenna module may include a PCB, a RFIC disposed on a first surface (e.g., the bottom surface) of the PCB or adjacent to the first surface and capable of supporting a designated high-frequency band (e.g., the mmWave band), and a plurality of antennas (e.g., array antennas) disposed on a second surface (e.g., the top or a side surface) of the PCB, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), and/or mobile industry processor interface (MIPI)).

According to an embodiment, commands or data may be transmitted or received between the electronic device 101 and the external electronic device (e.g., the electronic device 104) via the server 108 coupled with the second network 199. Each of the external electronic devices (e.g., the electronic device 102 and the electronic device 104) may be a device of a same type as, or a different type from, the electronic device 101. According to an embodiment, all or some of operations to be executed at the electronic device 101 may be executed at one or more of the external electronic devices (e.g., the electronic device 102, the electronic device 104, and the server 108). For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, for example, distributed computing or mobile edge computing. In an embodiment, the external electronic device (e.g., the electronic device 104) may include an Internet-of-things (IoT) device. The server 108 may be an intelligent server using machine learning and/or a neural network. According to an embodiment, the electronic device 104 or the server 108 may be included in the second network 199. The electronic device 101 may be applied to intelligent services (e.g., smart home, smart city, smart car, or healthcare) based on 5G communication technology or IoT-related technology.

The electronic devices according to the embodiments of the present disclosure may be one of various types of electronic devices. The electronic devices may include, for example, a portable communication device (e.g., a smart phone), a computer device, a portable multimedia device, a portable medical device, a camera, a wearable device, or a home appliance. According to an embodiment of the present disclosure, the electronic devices are not limited to those described above.

It should be appreciated that example embodiments of the present disclosure and the terms used in the present disclosure to describe the example embodiments are not intended to limit the technological features set forth herein to particular embodiments and are intended to include various changes, equivalents, or replacements for a corresponding embodiment. With regard to the description of the drawings, similar reference numerals may be used to refer to similar or related components. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms such as "1^{st}," and "2^{nd}," or "first" and "second" may be used to simply distinguish a corresponding component from another, and do not limit the components in other aspect (e.g., importance or order). It is to be understood that if a component (e.g., a first component) is referred to, with or without the term "operatively" or "communicatively," as "coupled with," "coupled to," "connected with," or "connected to" another component (e.g., a second component), the component may be coupled with the other component directly (e.g., wiredly), wirelessly, or via a third component.

As used in connection with embodiments of the present disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to embodiments of the present disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to embodiments, each component (e.g., a module or a program) of the above-described components may include a single entity or multiple entities, and some of the multiple entities may be separately disposed in different components. According to embodiments, one or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to embodiments, operations performed by the module, the program, or another component may be carried out sequentially, in parallel, repeatedly, or heuristically, or one or more of the operations may be executed in a different order or omitted, or one or more other operations may be added.

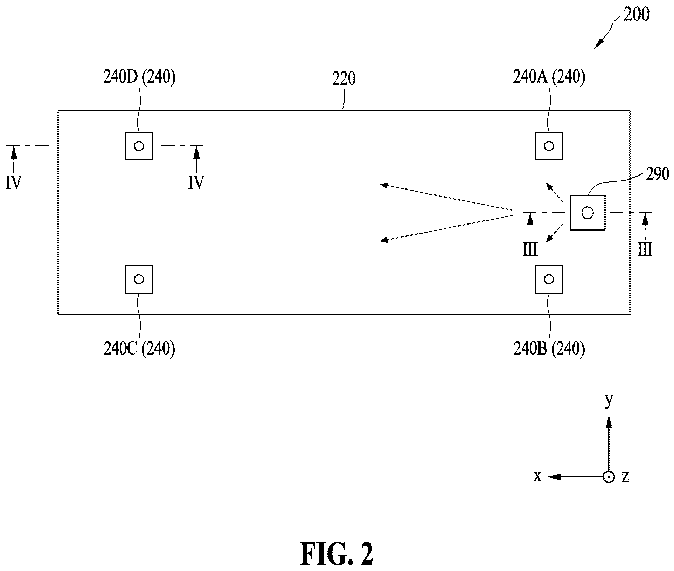

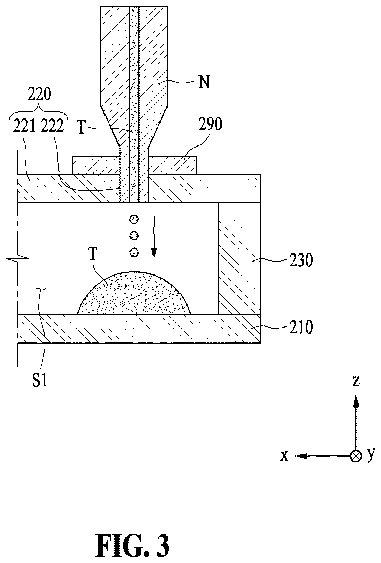

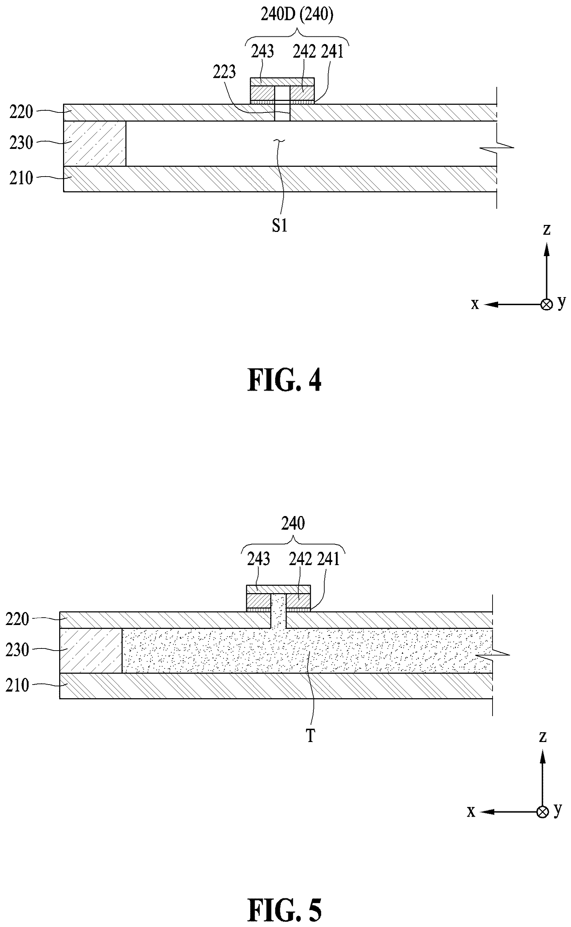

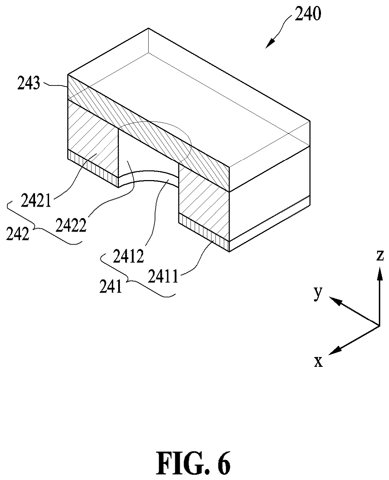

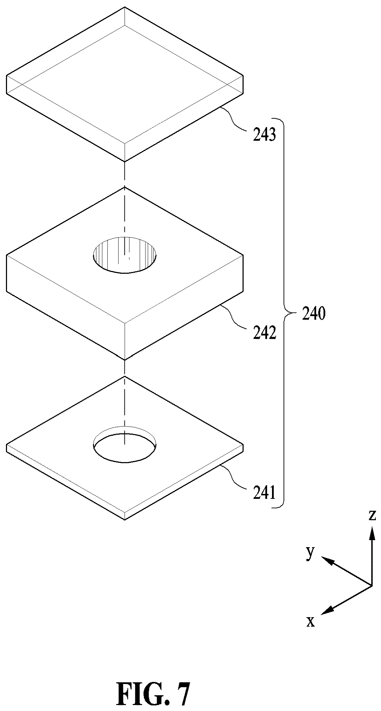

FIG. 2 is a plan view of a printed circuit board (PCB) structure containing a thermal interface material (TIM) according to an embodiment. FIG. 3 is a cross-sectional view taken along a line III-III of FIG. 2. FIG. 4 is a cross-sectional view taken along a line IV-IV of FIG. 2. FIG. 5 is a cross-sectional view of the PCB structure illustrating a state in which the inside of the PCB structure is filled with the TIM according to an embodiment. FIG. 6 is a cross-sectional perspective view of a cover structure according to an embodiment. FIG. 7 is an exploded perspective view of the cover structure according to an embodiment.

Referring to FIGS. 2 to 7, according to an embodiment, a PCB structure 200 may be provided in an electronic device (e.g., the electronic device 101 of FIG. 1). For example, at least one from among a processor (e.g., the processor 120 of FIG. 1), an input module (e.g., the input module 150 of FIG. 1), a sound output module (e.g., the sound output module 155 of FIG. 1), a display module (e.g., the display module 160 of FIG. 1), an audio module (e.g., the audio module 170 of FIG. 1), a sensor module (e.g., the sensor module 176 of FIG. 1), a haptic module (e.g., the haptic module 179 of FIG. 1), a camera module (e.g., the camera module 180 of FIG. 1), a power management module (e.g., the power management module 188 of FIG. 1), a communication module (e.g., the communication module 190 of FIG. 1), a subscriber identification module (e.g., the subscriber identification module 196 of FIG. 1), and an antenna module (e.g., the antenna module 197 of FIG. 1) of the electronic device (e.g., the electronic device 101 of FIG. 1) may include the PCB structure 200.

In an embodiment, the PCB structure 200 may contain a TIM T. The TIM T may be injected into the PCB structure 200. The TIM T may be injected into the PCB structure 200 in a liquid state and then hardened. The TIM T may assist in better transfer of heat within the PCB structure 200.

In an embodiment, the PCB structure 200 may include a plurality of components that require cooling. For example, the PCB structure 200 may include an application processor (AP) or a power amplifier (PA). Such components generate heat and thus, may correspond to thermal sources. For the normal operation of these components, sufficient cooling is required. The TIM T that fills the PCB structure 200 may absorb heat from the thermal sources and spread the heat over a large area.

In an embodiment, the PCB structure 200 may include a first PCB 210, a second PCB 220, an interposer 230, and a cover structure 240. The first PCB 210, the second PCB 220, and the interposer 230 may define an inner space S1. The inner space S1 may be a space surrounded by the first PCB 210, the second PCB 220, and the interposer 230.

In an embodiment, the first PCB 210 may include a PCB. For example, the first PCB 210 may be a PCB including a rigid material. For example, the first PCB 210 may be a flexible printed circuit board (FPCB) including a flexible material. The first PCB 210 may have a flat plate shape. The shape of the first PCB 210 is shown as a rectangular parallelepiped, but is not limited thereto.

In an embodiment, the second PCB 220 may be provided at a position spaced apart from the first PCB 210. The second PCB 220 may be spaced apart from the first PCB 210 in the z-axis direction. The stacking direction of the first PCB 210, the interposer 230, and the second PCB 220 may be parallel to the z-axis direction. A nozzle hole 222 and a monitoring hole 223 may be formed through the second PCB 220. The second PCB 220 may include a cover body 221, the nozzle hole 222, and the monitoring hole 223.

In an embodiment, the cover body 221 may include a PCB. For example, the cover body 221 may be a PCB including a rigid material. For example, the cover body 221 may be an FPCB including a flexible material. The cover body 221 may have a flat plate shape.

In an embodiment, the nozzle hole 222 may be formed through the cover body 221. Through the nozzle hole 222, the TIM T may be injected into the inner space S1. The TIM T injected into the inner space S1 may travel in the x-axis direction and/or the y-axis direction. A nozzle block 290 may be disposed on the nozzle hole 222.

In an embodiment, the nozzle block 290 may be disposed on the second PCB 220. The nozzle block 290 may assist a nozzle N to stably inject the TIM T into the PCB structure 200. The nozzle block 290 may have a hole to accommodate a portion of the nozzle N. The hole of the nozzle block 290 may communicate with the nozzle hole 222. While mounted on the nozzle block 290, the nozzle N may inject the TIM T into the PCB structure 200.

In an embodiment, the monitoring hole 223 may be formed through the cover body 221. Through the monitoring hole 223, the inner space S1 may be exposed to the outside. Here, being exposed means that the inner space S1 is visible from the outside. The monitoring hole 223 may be covered by the cover structure 240.

In an embodiment, the interposer 230 may be disposed between the first PCB 210 and the second PCB 220. The interposer 230 may be connected to the first PCB 210. The first PCB 210 may be connected to the second PCB 220. The interposer 230 may electrically connect the components disposed on the first PCB 210 and the components disposed on the second PCB 220. The interposer 230 may be connected to the first PCB 210 and the second PCB 220 through at least one solder ball.

In an embodiment, the cover structure 240 may be disposed on the second PCB 220. The cover structure 240 may overlap the monitoring hole 223. For example, the cover structure 240 may overlap the monitoring hole 223 in the z-axis direction. The cover structure 240 may include a mounting layer 241, a support layer 242, and a visible layer 243.

In an embodiment, a plurality of the cover structure 240 may be provided. The plurality of the cover structure 240 may include a first cover structure 240A, a second cover structure 240B, a third cover structure 240C, and a fourth cover structure 240D. In an embodiment, the plurality of the cover structures 240 may be provided at positions spaced apart from each other on the second PCB 220. The first cover structure 240A and the second cover structure 240B may be provided on opposite sides relative to the nozzle block 290. The second cover structure 240B and the third cover structure 240C may be at different distances from the nozzle block 290.

In an embodiment, the mounting layer 241 may be connected to the second PCB 220. The mounting layer 241 may include, for example, a metal material. For example, the mounting layer 241 may include lead in the second PCB 220. For example, the mounting layer 241 may be surface-mounted on the second PCB 220.

In an embodiment, the mounting layer 241 may include a base layer 2411 and a base hole 2412 formed through the base layer 2411. The base hole 2412 may communicate with the monitoring hole 223. When the inner space S1 is sufficiently filled with the TIM T, the TIM T may move through the monitoring hole 223. The TIM T passing through the monitoring hole 223 may enter the cover structure 240.

In an embodiment, the support layer 242 may be disposed on the second PCB 220. The support layer 242 may be disposed directly on the second PCB 220 or on the second PCB 220 with another layer therebetween. For example, the mounting layer 241 may be provided between the support layer 242 and the second PCB 220. A hole overlapping the monitoring hole 223 may be formed through the support layer 242. The support layer 242 may be provided on a surface of the mounting layer 241 that faces away from the second PCB 220. The support layer 242 may include a flexible material. For example, the support layer 242 may include rubber. The material of the support layer 242 is not limited thereto. For example, the support layer 242 may include a rigid material. The support layer 242 may include a non-conductive material. For example, the support layer 242 may include fiberglass epoxy laminate. The support layer 242 may include, for example, an insulation material. The support layer 242 may be attached to the mounting layer 241. In an embodiment, the support layer 242 may be directly connected to the mounting layer 241, but embodiments are not limited thereto. For example, a different component may be provided between the support layer 242 and the mounting layer 241. The support layer 242 may include a body part 2421 and a body hole 2422 formed through the body part 2421. The body hole 2422 may communicate with the base hole 2412.

In an embodiment, the height of the support layer 242 may be greater than the height of the mounting layer 241. The TIM T may move along the support layer 242. As the inside of the support layer 242 is filled with the TIM T, the color of the inside of the support layer 242 exposed to the outside may change.

In an embodiment, the visible layer 243 may be connected to the support layer 242 and cover the monitoring hole 223. The visible layer 243 may prevent the TIM T passing through the monitoring hole 223 from being discharged to the outside. The visible layer 243 may include a material with transparency. For example, the visible layer 243 may include a transparent or translucent material. The visible layer 243 may physically block the travel path of the TIM T. The visible layer 243 may block the TIM T from being discharged to the outside through the monitoring hole 223. The visible layer 243 may allow a user to observe the inside of the PCB structure 200. The visible layer 243 may cover (e.g., close) the base hole 2412.

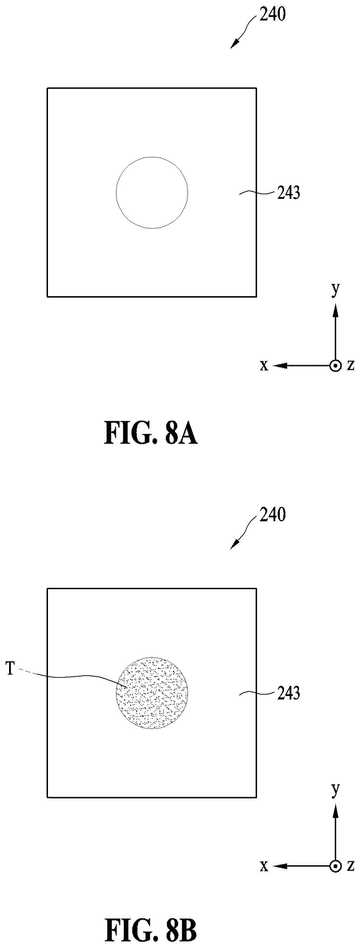

FIG. 8A is a plan view of a cover structure according to an embodiment. FIG. 8B is a plan view of the cover structure in a state in which the inside of a PCB structure is filled with a TIM according to an embodiment.

Referring to FIGS. 8A and 8B, the cover structure 240 may include the visible layer 243. The visible layer 243 may include a material with transparency. As the visible layer 243 includes a material with transparency, the inner space may be visible from the outside.

In an embodiment, when the inside of the cover structure 240 is filled with the TIM T, the color of a portion exposed to the outside through the visible layer 243 may change. An operator may check the color of the visible layer 243 while injecting the TIM T into the PCB structure using the nozzle. For example, the user may visually check the color of the visible layer 243, or check a change in the color of the visible layer 243 through a vision device. For example, when a vision device is used, the vision device may radiate light into the inside of the PCB structure, detect the degree of reflection, and detect whether the PCB structure is sufficiently filled with the TIM T. The color of the inside of the support layer 242 visible through the visible layer 243 may change as the PCB structure is filled with the TIM T.

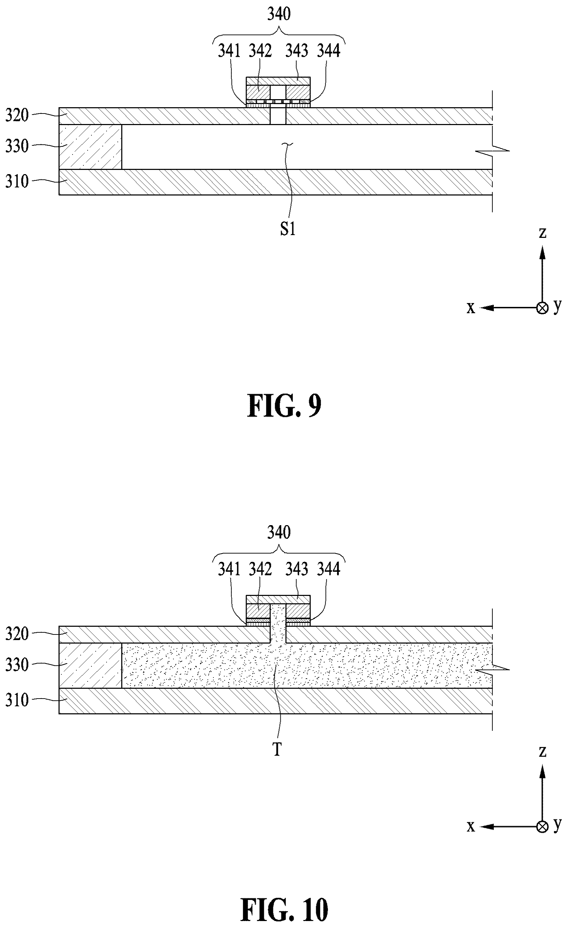

FIG. 9 is a cross-sectional view of a PCB structure according to an embodiment. FIG. 10 is a cross-sectional view of a PCB structure illustrating a state in which the inside of the PCB structure is filled with a TIM according to an embodiment.

Referring to FIGS. 9 and 10, a PCB structure may include a first PCB 310, a second PCB 320, an interposer 330, and a cover structure 340. The cover structure 340 may include a mounting layer 341, a support layer 342, a visible layer 343, and a mesh layer 344. The cover structure 340 may allow an inner space S1, which is filled with a TIM T, to be visible from the outside. The cover structure 340 may assist in preventing the TIM T from being discharged to the outside. While the PCB structure is sufficiently filled with the TIM T, the TIM T may enter the inside of the cover structure 340. The TIM T may pass through the mesh layer 344. In a state before the TIM T passes through the mesh layer 344, the mesh layer 344 may be observed from the outside through the visible layer 343. In a state in which the support layer 342 is filled with the TIM T passing through the mesh layer 344, the mesh layer 344 may be occluded by the TIM T. In other words, the mesh layer 344 may not be observed from the outside.

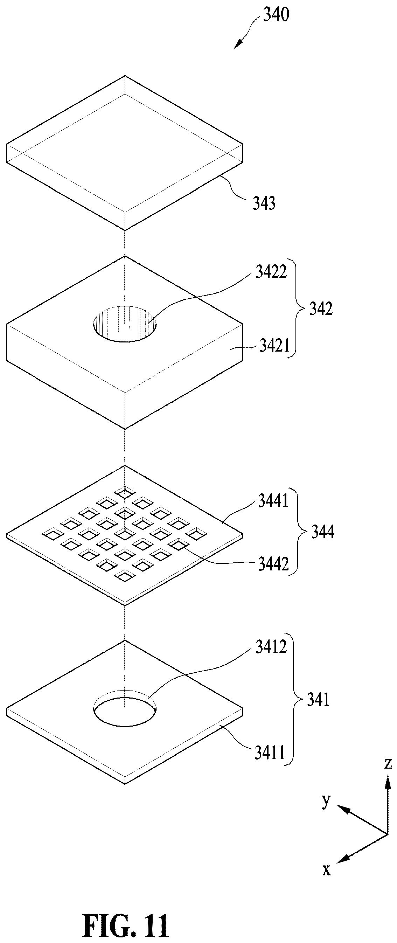

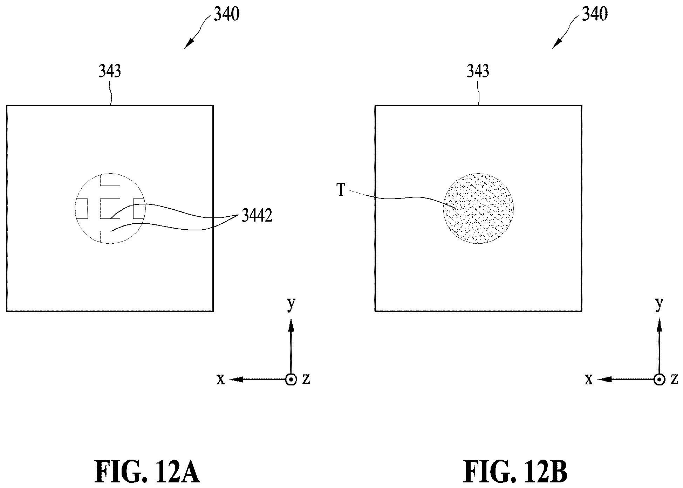

FIG. 11 is an exploded perspective view of a cover structure according to an embodiment. FIG. 12A is a plan view of the cover structure according to an embodiment. FIG. 12B is a plan view of the cover structure in a state in which the inside of a PCB structure is filled with a TIM according to an embodiment.

Referring to FIGS. 11 to 12B, the cover structure 340 may include the mounting layer 341, the support layer 342, the visible layer 343, and the mesh layer 344. The mounting layer 341 may include a base layer 3411 and a base hole 3412 formed through the base layer 3411. The support layer 342 may include a body part 3421 and a body hole 3422 formed through the body part 3421. The mesh layer 344 may be disposed between the mounting layer 341 and the support layer 342. The mesh layer 344 may include a mesh layer body 3441 and a plurality of mesh holes 3442 formed through the mesh layer body 3441. The size of the plurality of mesh holes 3442 may be smaller than the size of the base hole 3412 or the body hole 3422. The plurality of mesh holes 3442 may be observed from the outside in a state in which the cover structure 340 is not filled with the TIM T. In a state in which the support layer 342 is filled with the TIM T, the plurality of mesh holes 3442 may be occluded by the TIM T. In other words, the mesh layer 344 may not be observed from the outside.

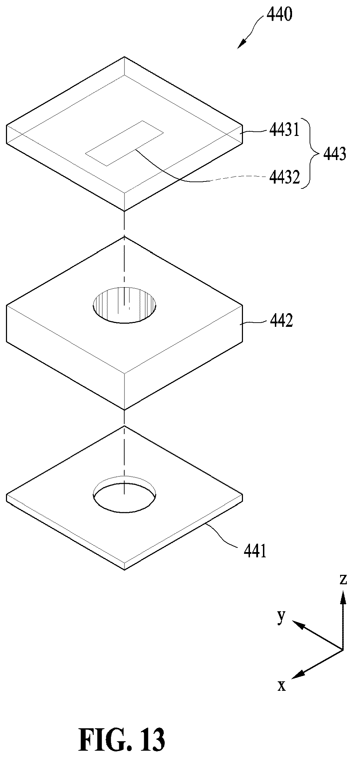

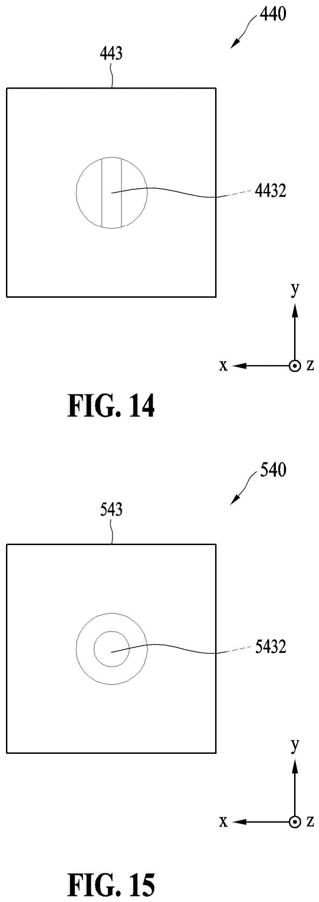

FIG. 13 is an exploded perspective view of a cover structure according to an embodiment. FIG. 14 is a plan view of a cover structure according to an embodiment.

Referring to FIGS. 13 and 14, a cover structure 440 may include a mounting layer 441, a support layer 442, and a visible layer 443. The mounting layer 441 may include a base layer and a base hole formed through the base layer. The support layer 442 may include a body part (e.g., base layer 2411 of FIG. 6) and a body hole (e.g., a base hole 2412 of FIG. 6) formed through the body part.

In an embodiment, the visible layer 443 may include a cover body 4431 and a print pattern 4432 formed on the cover body 4431. The cover body 4431 may have a plate shape. The print pattern 4432 may be formed in a portion, of the cover body 4431, which overlaps the body hole of the support layer 442. For example, the print pattern 4432 may be formed on a surface, of the cover body 4431, which faces the support layer 442.

In an embodiment, in a state in which the inside of the support layer 442 is not filled with the TIM, the print pattern 4432 may be visible from the outside through the visible layer 443. In a state in which the inside of the support layer 442 is filled with the TIM, the print pattern 4432 may be invisible from the outside as occluded by the TIM. The print pattern 4432 may have a rectangular shape. However, the shape of the print pattern 4432 is not limited thereto.

FIG. 15 is a plan view of a cover structure according to an embodiment.

Referring to FIG. 15, a cover structure 540 may include a visible layer 543. The visible layer 543 may include a material with transparency. The visible layer 543 may include a print pattern 5432. The print pattern 5432 may have a circular shape. The print pattern 5432 may be occluded by a TIM when the inside of the cover structure 540 is filled with the TIM.

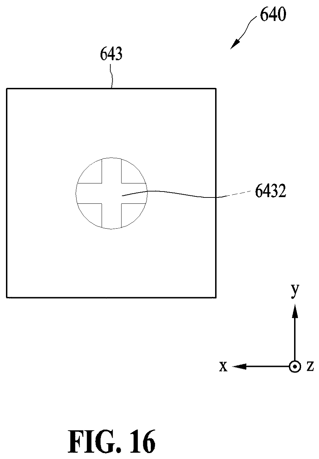

FIG. 16 is a plan view of a cover structure according to an embodiment.

Referring to FIG. 16, a cover structure 640 may include a visible layer 643. The visible layer 643 may include a material with transparency. The visible layer 643 may include a print pattern 6432. The print pattern 6432 may have a cross shape. The print pattern 6432 may be occluded by a TIM when the inside of the cover structure 640 is filled with the TIM.

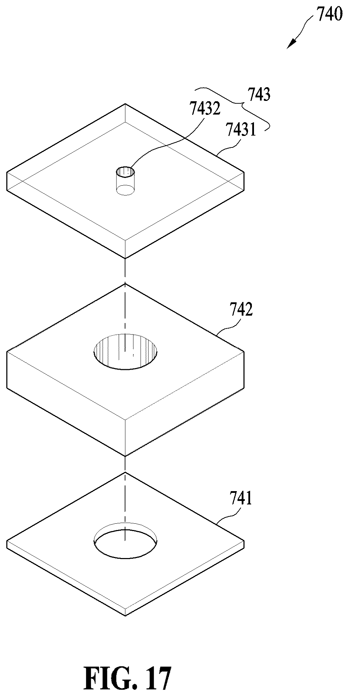

FIG. 17 is an exploded perspective view of a cover structure according to an embodiment.

Referring to FIG. 17, a cover structure 740 may include a mounting layer 741, a support layer 742, and a visible layer 743. The visible layer 743 may include a cover body 7431 having a material with transparency, and a vent hole 7432 formed through the cover body 7431 and provided in a portion overlapping a body hole of the support layer 742. The vent hole 7432 may discharge air inside the PCB structure to the outside. As the vent hole 7432 is provided in the cover structure 740, the PCB structure may not have a separate vent hole on the second PCB.

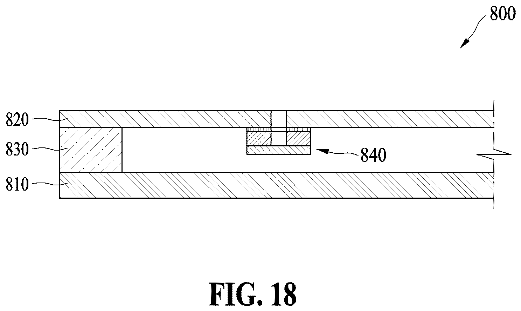

FIG. 18 is a cross-sectional view of a PCB structure according to an embodiment.

Referring to FIG. 18, a PCB structure 800 may include a first PCB 810, a second PCB 820, an interposer 830, and a cover structure 840. The first PCB 810, the second PCB 820, and the interposer 830 may define an inner space S1 (refer to FIG. 4). The inner space S1 may be a space surrounded by the first PCB 810, the second PCB 820, and the interposer 830.

In an embodiment, the cover structure 840 may be positioned in the inner space S1. The cover structure 840 may be positioned between the first PCB 810 and the second PCB 820. This structure may prevent the cover structure 840 from being exposed to the outside, thereby implementing a structurally compact shape.

According to an embodiment, an electronic device includes a PCB structure containing a TIM, wherein the PCB structure 200 may include a first PCB 210, an interposer 230 connected to the first PCB, a second PCB 220 including a cover body 221 connected to the interposer, a nozzle hole 222 formed through the cover body, and a monitoring hole 223 formed through the cover body, and a cover structure 240 including a mounting layer 241 which is connected to the second PCB and has a base hole 2412 communicating with the monitoring hole, a support layer 242 which is provided on a surface of the mounting layer that faces away from the second PCB and has a body hole 2422 communicating with the base hole, and a visible layer 243 which is connected to the support layer, covers the monitoring hole, and has a material having transparency.

In an embodiment, the visible layer 243 may block the TIM from being discharged to the outside through the monitoring hole.

In an embodiment, in a state in which an inside of the support layer is filled with the TIM, a color of the inside of the support layer 242 visible through the visible layer 243 may change.

In an embodiment, the support layer 242 may include a non-conductive material.

In an embodiment, the support layer 242 may include rubber.

In an embodiment, the mounting layer 241 may be surface-mounted on the second PCB, the support layer 242 may be adhered to the mounting layer, and the visible layer 243 may be adhered to the mounting layer.

In an embodiment, a height (e.g., a thickness) of the support layer 242 may be greater than a height (e.g., a thickness) of the mounting layer.

In an embodiment, the cover structure 240 may further include a mesh layer disposed between the mounting layer and the support layer.

In an embodiment, the mesh layer 344 may include a plurality of mesh holes having a smaller size than a size of the body hole.

In an embodiment, in a state in which an inside of the support layer is not filled with the TIM, the plurality of mesh holes 3442 may be visible from the outside through the visible layer, and in a state in which the inside of the support layer is filled with the TIM, the plurality of mesh holes 3442 may not be visible from the outside due to occlusion by the TIM.

In an embodiment, the visible layer 443 may include a cover body 4431 having a material having transparency, and a print pattern 4432 formed in a portion, of the cover body, which overlaps the body hole.

In an embodiment, in a state in which an inside of the support layer is not filled with the TIM, the print pattern 4432 may be visible from the outside through the visible layer, and in a state in which the inside of the support layer is filled with the TIM, the print pattern 4432 may not be visible from the outside due to occlusion by the TIM.

In an embodiment, the visible layer 743 may include a cover body 7431 having a material having transparency, and a vent hole 7432 formed through the cover body and provided in a portion, of the cover body, which overlaps the body hole.

In an embodiment, the cover structure 840 may be provided between the first PCB and the second PCB.

In an embodiment, the cover structure 240 may be provided in a plurality, and at least a portion of the plurality of cover structures 240 may be spaced apart from the nozzle hole by different distances.

According to an embodiment, a PCB structure containing a TIM may include a first PCB 210, an interposer 230 connected to the first PCB, a second PCB 220 including a cover body 221 connected to the interposer, a nozzle hole 222 formed through the cover body, and a monitoring hole 223 formed through the cover body, and a cover structure 240 including a mounting layer 241 which is connected to the second PCB and has a base hole 2412 communicating with the monitoring hole, a support layer 242 which is provided on a surface of the mounting layer that faces away from the second PCB and has a body hole 2422 communicating with the base hole, and a visible layer 243 which is connected to the support layer, covers the monitoring hole, and has a material including transparency.

In an embodiment, the visible layer 243 may block the TIM from being discharged to the outside through the monitoring hole.

In an embodiment, a height (e.g., thickness) of the support layer 242 may be greater than a height (e.g., thickness) of the mounting layer.

In an embodiment, the visible layer 443 may include a cover body 4431 having a material having transparency, and a print pattern 4432 formed in a portion, of the cover body, which overlaps the body hole.

According to an embodiment, an electronic device may include a PCB structure containing a TIM, wherein the PCB structure may include a first PCB 210, an interposer 230 connected to the first PCB, a second PCB 220 including a cover body 221 connected to the interposer, a nozzle hole 222 formed through the cover body, and a monitoring hole 223 formed through the cover body, and a cover structure 240 including a mounting layer 241 which is connected to the second PCB and has a base hole 2412 communicating with the monitoring hole, a support layer 242 which is provided on a surface of the mounting layer that faces away from the second PCB and has a body hole 2422 communicating with the base hole, and a visible layer 243 which is connected to the support layer, covers the monitoring hole, and has a material having transparency, wherein the visible layer 243 may block the thermal interface material from being discharged to the outside through the monitoring hole, include a non-conductive material, and have a height (e.g., thickness) greater than a height (e.g., thickness) of the mounting layer.

The effects of an electronic device according to embodiments of the present disclosure are not limited to the above-mentioned effects, and other unmentioned effects can be clearly understood from the above description by one of ordinary skill in the art.

The example embodiments of the present disclosure described above and shown in the drawings are intended to be illustrative and not restrictive. Various modifications may be made to embodiments of the present disclosure. Any of the embodiment(s) described herein may be used in combination with any other embodiment(s) described herein.

## Claims

1. An electronic device comprising a printed circuit board (PCB) structure containing a thermal interface material (TIM),
wherein the PCB structure 200 comprises:
a first PCB 210;
an interposer 230 connected to the first PCB;
a second PCB 220 connected to the interposer 230, wherein a nozzle hole 222 and a monitoring hole 223 are formed therethrough; and
a cover structure 240 comprising a support layer 242 disposed on the second PCB 220, and a visible layer 243 which is connected to the support layer, covers the monitoring hole, and comprises a material with transparency, wherein a hole overlapping the monitoring hole 223 is formed therethrough.

2. The electronic device of claim 1, wherein the visible layer 243 blocks the thermal interface material from being discharged to the outside through the monitoring hole.

3. The electronic device of claim 1 or 2, wherein in a state in which an inside of the support layer is filled with the thermal interface material, a color of the inside of the support layer 242 visible through the visible layer 243 changes.

4. The electronic device of any one of claims 1 to 3, wherein the support layer 242 comprises a non-conductive material.

5. The electronic device of any one of claims 1 to 4, wherein the support layer 242 comprises rubber or fiberglass epoxy laminate.

6. The electronic device of any one of claims 1 to 5, wherein
the cover structure 240 further comprises a mounting layer 241 disposed between the second PCB and the support layer and surface-mounted on the second PCB,
a hole is formed through the mounting layer,
the support layer 242 is adhered to the mounting layer, and the visible layer 243 is adhered to the mounting layer.

7. The electronic device of any one of claims 1 to 6, wherein a height of the support layer 242 is greater than a height of the mounting layer.

8. The electronic device of any one of claims 1 to 7, wherein the cover structure 223 further comprises a mesh layer disposed between the mounting layer and the support layer.

9. The electronic device of any one of claims 1 to 8, wherein the mesh layer 344 comprises a plurality of mesh holes having a smaller size than the hole formed through the support layer.

10. The electronic device of any one of claims 1 to 9, wherein
in a state in which an inside of the support layer is not filled with the thermal interface material, the plurality of mesh holes 3442 is visible from the outside through the visible layer, and
in a state in which the inside of the support layer is filled with the thermal interface material, the plurality of mesh holes 3442 is invisible from the outside as occluded by the thermal interface material.

11. The electronic device of any one of claims 1 to 10, wherein the visible layer 443 comprises:
a cover body 4431 comprising a material with transparency; and
a print pattern 4432 formed in a portion, of the cover body, which overlaps the hole formed in the support layer.

12. The electronic device of any one of claims 1 to 11, wherein
in a state in which an inside of the support layer is not filled with the thermal interface material, the print pattern 4432 is visible from the outside through the visible layer, and
in a state in which the inside of the support layer is filled with the thermal interface material, the print pattern 4432 is invisible from the outside as occluded by the thermal interface material.

13. The electronic device of any one of claims 1 to 12, wherein the visible layer 743 comprises:
a cover body 7431 comprising a material with transparency; and
a vent hole 7432 formed through the cover body and provided in a portion, of the cover body, which overlaps the hole formed in the support layer.

14. The electronic device of any one of claims 1 to 13, wherein the cover structure 840 is provided between the first PCB and the second PCB.

15. The electronic device of any one of claims 1 to 14, wherein the cover structure 240, 240A, 240B, 240C is provided in a plurality, and at least a portion of the plurality of cover structures 240, 240A, 240B, and 240C are spaced apart from the nozzle hole by different distances.
